Europäisches Patentamt

European Patent Office

Office européen des brevets

(19)

(11) **EP 0 511 434 B1**

(12) **EUROPÄISCHE PATENTSCHRIFT**

(45) Veröffentlichungstag und Bekanntmachung des Hinweises auf die Patenterteilung:
**27.10.1999 Patentblatt 1999/43**

(51) Int Cl.6: **G01R 33/04**

(21) Anmeldenummer: **91121010.2**

(22) Anmeldetag: **07.12.1991**

(54) **Anordnung zum Messen eines flussarmen Magnetfeldes**

Device for measuring a low-flux magnetic field

Dispositif de mesure d'un champ magnétique à flux bas

(84) Benannte Vertragsstaaten:
**CH DE DK ES FR GB IT LI NL SE**

(30) Priorität: **26.04.1991 CH 126291**

(43) Veröffentlichungstag der Anmeldung:
**04.11.1992 Patentblatt 1992/45**

(73) Patentinhaber: **MARS, INCORPORATED**
**McLean, Virginia 22101-3883 (US)**

(72) Erfinder: **Seitz, Thomas**
**CH-6300 Zug (CH)**

(74) Vertreter: **Burke, Steven David et al**
**R.G.C. Jenkins & Co.**
**26 Caxton Street**
**London SW1H 0RJ (GB)**

(56) Entgegenhaltungen:
EP-A- 0 284 196          WO-A-88/03654
DE-A- 3 738 455          US-A- 3 040 247
US-A- 4 764 725

Bemerkungen:
Die Akte enthält technische Angaben, die nach dem Eingang der Anmeldung eingereicht wurden und die nicht in dieser Patentschrift enthalten sind.

**Beschreibung**

Die Erfindung bezieht sich auf eine Anordnung zum Messen eines Magnetfeldes nach dem Kernsaturations - Prinzip.

Das Magnetfeld ist vorzugsweise ein von magnetisierter magnetischer Tinte erzeugtes flußarmes Magnetfeld $H_o$. Die Anordnung kann dann z. B. in einem Banknotenerkennungsautomat eingesetzt werden zur Detektion und/oder zum Lesen eines mittels magnetischer Tinte ausgeführten Schriftbildes, welches sich z. B. auf einer US-, JP- oder DE-Banknote befindet. Zu diesem Zweck muss die Banknote vor der Detektion bzw. vor dem Lesen mittels eines starken Permanentmagneten magnetisiert werden. Die extrem schwachen, von der magnetisierten magnetischen Tinte einer Banknote herrührenden Magnetfelder weisen einen Wert in der Grössenordnung von $10^{-7}$ Tesla ($10^{-3}$ Gauss) auf, wobei das immer vorhandene Erdmagnetfeld bereits mit $5 \times 10^{-5}$ Tesla (0,5 Gauss) eine Stärke besitzt, die um zirka drei Grössenordnungen grösser ist.

Aus der US-A 4 864 238 ist eine Anordnung bekannt, die einen nach dem Kernsaturations-Prinzip arbeitenden, äusserst empfindlichen Sensor enthält, der die extrem schwachen, von der magnetisierten magnetischen Tinte einer Banknote herrührenden Magnetfelder misst, wobei in einer dem Sensor nachfolgenden Auswerteeinrichtung eine zweite Harmonische der Sensorausgangsspannung ausgewertet wird. Dieser Sensor enthält eine dreidimensionale Spule, deren Herstellung und/oder Montage relativ teuer ist und die fast unmöglich identisch reproduzierbar ist, was Anordnungen verunmöglicht oder mindestens stark verteuert, die zwei identische Sensoren benötigen, die dann durch Auslesen aus einer Unmenge von hergestellten Sensoren herausgesucht werden müssen.

Eine weitere nach dem Kernsaturations-Prinzip arbeitende Vorrichtung zum Messen von Magnetfeldern ist in EP-A-0505619 beschrieben. Dies ist die Veröffentlichung einer früheren europäischen Patentanmeldung, die zum Stand der Technik nach Art. 54(3) EPÜ gehört. Die dort beschriebene Vorrichtung ist mit einem einzelnen Kernsaturations-Sensor versehen, der in mehreren flachen, parallelen Schichten eine Erregerspule, eine Meßspule und einen Magnetkern aufweist.

Der Erfindung liegt die Aufgabe zugrunde, die bekannte Anordnung so zu verbessern, dass sie sehr preisgünstig herstellbar ist, dass eine hochpräzise Herstellung praktisch identischer Sensoren möglich ist und dass in einer dem Sensor nachfolgenden Auswerteeinrichtung kein Filter mehr notwendig ist zum Ausfiltern einer Harmonischen aus der Sensorausgangsspannung.

Die genannte Aufgabe wird erfindungsgemäss durch die in Anspruch 1 angegebene Vorrichtung gelöst.

Vorteilhafte Ausgestaltungen der Erfindung ergeben sich aus den Unteransprüchen.

Ausführungsbeispiele der Erfindung sowie ein zu deren Verständnis nützliches Beispiel einer Anordnung zur Messung eines Magnetfelds sind in der Zeichnung dargestellt und werden im folgenden näher beschrieben.

Es zeigen:

Fig. 1      ein schematisches elektrisches Schaltbild einer Anordnung zur Messung eines Magnetfelds,
Fig. 2      eine kennlinienmässige Darstellung des Kernsaturations-Prinzips,
Fig. 3      einen Querschnitt eines in der Anordnung nach Fig. 1 verwendeten Sensors mit Banknote,
Fig. 4      eine Draufsicht des in der Fig. 3 dargestellten Sensors mit einer ersten Kernvariante und ohne Banknote,
Fig. 5      eine Draufsicht einer zweiten Kernvariante,
Fig. 6      eine Draufsicht einer dritten Kernvariante,
Fig. 7      ein elektrisches Schaltbild einer erfindungsgemässen Anordnung,
Fig. 8      ein elektrisches Schaltbild einer Variante der erfindungsgemässen Anordnung,
Fig. 9      einen schematischen Querschnitt eines in der erfindungsgemässen Anordnung verwendeten Sensors mit Banknote und
Fig. 10    eine Draufsicht des in der Fig. 8 dargestellten und in der erfindungsgemässen Anordnung verwendeten Sensors mit der zweiten Kernvariante und ohne Banknote.

Gleiche Bezugszahlen bezeichnen in allen Figuren der Zeichnung gleiche Teile.

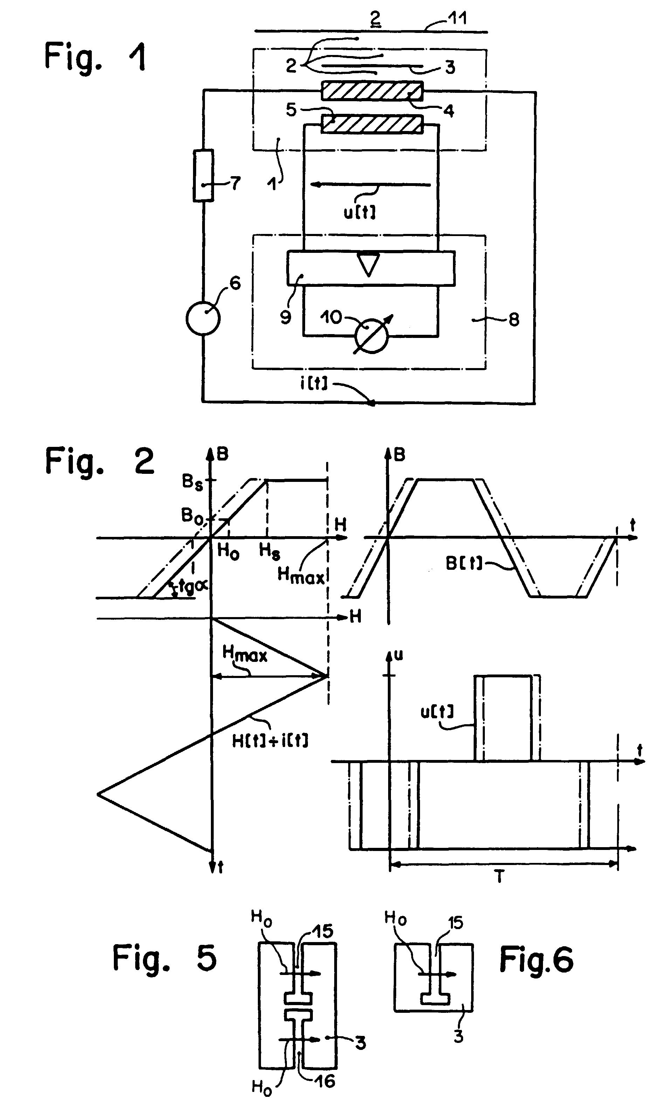

Die in der Fig. 1 dargestellte und zum Verständnis der Erfindung nützliche Anordnung enthält mindestens einen Sensor 1, der einen, mindestens einen Luftspalt 2 und einen ferromagnetischen Kern 3 aufweisenden Magnetkreis 2;3 sowie mindestens eine Erregerspule 4 und eine Messpule 5 aufweist. Die beiden Spulen 4 und 5 sind induktiv miteinander gekoppelt und auf einer gleichen, in der Darstellung der Zeichnung unteren Seite des Kerns 3 angeordnet. Ein Generator 6 speist die Erregerspule 4 über einen Vorwiderstand 7 mit einem zeitlich periodisch variablen Erregerstrom i[t] der Periode T. Der zeitlich variable Erregerstrom i[t] ist vorzugsweise in Funktion der Zeit t ein sägezahnförmiger Erregerstrom, er kann jedoch auch z. B. ein sinusförmiger Erregerstrom sein. Ein sägezahnförmiger Erregerstrom i[t] und damit eine sägezahnförmige Erregung des Kerns 3 erzeugt bei gleicher Aussteuerung weniger Verluste als ein sinusförmiger Erregerstrom i[t]. Die beiden Pole der Messpule 5 bilden einen zweipoligen Ausgang des Sensors 1, an dem im Betrieb eine Ausgangsspannung u[t] ansteht. In der in der Fig. 1 dargestellten Anordnung ist ausserdem eine Anordnung 8 vorhanden zur Auswertung des Wertes einer Oberwelle der Ausgangspannung u[t] des Sensors 1. Der Ausgang des Sensors 1 ist auf einen Eingang der Anordnung 8 geführt, die in der angegebenen Reihenfolge z. B. aus einer Kaskadenschaltung eines Verstärkers 9 und eines Voltmeters 10 besteht, wobei der Verstärker 9 in der ersten Variante ein Bandpassverstärker ist, der die betreffende auszuwertende Oberwelle aus dem Frequenzspektrum der Ausgangsspannung u[t] herausfiltert und verstärkt. Das Voltmeter 10 ist ein Wechselspannungsvoltmeter und misst z. B. den Effektivwert der Ausgangsspannung des Verstärkers 9, d. h. der herausgefilterten verstärkten Oberwelle. Eine mit magnetisierter magnetischer Tinte bedruckte Banknote 11 befindet sich anlässlich ihrer Auswertung mindestens zeitweise in der Nähe des Kerns 3 innerhalb des Luftspaltes 2 und zwar auf der von den beiden Spulen 4 und 5 abgewandten Seite des Kerns 3. Der Kern 3 ist ein flacher Kern und die Banknote 11 ist während der Auswertung in einem Abstand bis zu zirka 1 mm parallel zum Kern 3 angeordnet.

Der Sensor 1 arbeitet nach dem Kernsaturations-Prinzip. Da letzteres an sich bekannt und u. a. im oben angegebenen Stand der Technik beschrieben ist, wird es nur zum besseren Verständnis der Erfindung nachfolgend anhand der Fig. 2 kurz beschrieben.

In der Fig. 2 ist oben links eine idealisierte Kennlinie B[H] der effektiven Induktion B des Magnetkreises 2;3 in Funktion des vom Erregerstrom i[t] erzeugten Erregermagnetfeldes H[t] dargestellt, wobei die Hysteresis des ferromagnetischen Kerns 3 vernachlässigt und die Kennlinie ausserhalb der Sättigung als linear angenommen wurde. Die Erregerspule 4 wird im Betrieb mit dem periodischen elektrischen Strom i[t] gespeist, der stark genug ist, um den ferromagnetischen Kern 3 mindestens zeitweise in die magnetische Sättigung zu treiben. Die Frequenz des periodischen zeitvariablen Erregerstromes i[t] ist vorzugsweise 20 bis 200 kHz und die Messspule 5 weist z. B. 100 Windungen auf. $B_s$ bezeichnet in der Fig. 2 die Sättigungsinduktion, die einem Sättigungsmagnetfeld $H_s$ entspricht. Unten links in der Fig. 2 ist in Funktion der Zeit t das den Magnetkreis 2;3 erregende Erregermagnetfeld H[t] dargestellt, welches proportional zum Erregerstrom i[t] durch den letzteren mit Hilfe der Erregerspule 4 erzeugt wird. In der Fig. 2 gilt die Annahme, dass der Erregerstrom i[t] und damit auch das Erregermagnetfeld H[t] in Funktion der Zeit t sägezahnförmig sind. Die Amplitude $H_{max}$ des sägezahnförmigen Erregermagnetfeldes H[t] ist so gross gewählt, dass der ferromagnetische Kern 3 periodisch in die Sättigung gesteuert wird. Dadurch erhält die im Magnetkreis 2;3 vorhandene magnetische Induktion B[t] in Funktion der Zeit t einen periodisch trapezförmigen Verlauf, welcher in der Fig. 2 oben rechts dargestellt ist. Die Flanken des trapezförmigen Verlaufs erzeugen durch magnetische Induktion in der Messspule 5 die periodische Spannung u[t] der Periode T, deren zeitlicher Verlauf aus einer Reihe abwechselnd positiver und negativer rechteckförmiger Spannungsimpulse besteht.

Durch Einwirken eines äusseren Magnetfeldes $H_o$, z. B. des Magnetfelds der magnetisierten magnetischen Tinte einer Banknote, dem eine magnetische Induktion $B_o$ entspricht, entstehen die in der Fig. 2 strichpunktiert dargestellten Kennlinien. Insbesondere erhalten die rechteckförmigen Spannungsimpulse der Ausgangsspannung u[t] in Richtung der Zeitachse eine Asymmetrie, deren Wert zum Messen des Wertes des äusseren Magnetfeldes $H_o$ ausgenutzt werden kann. In jedem Fall besteht die periodische Ausgangsspannung u[t] gemäss einer Fourier-Analyse aus einer, mit einer laufenden Nummer Eins versehenenen Grundwelle und einer Vielzahl, bei zwei beginnend, fortlaufend durchnummerierter Oberwellen. Die laufende Nummer der Grundwelle und der Oberwellen wird nachfolgend mit n bezeichnet. Erscheint in der Nähe des Sensors 1, d. h. im Luftspalt 2, die magnetisierte magnetische Tinte einer Banknote, dann tritt das volle Spektrum der Oberwellen der Ausgangsspannung u[t] des Sensors 1 in Erscheinung.

Gemäss der Fourier-Analyse ist die Amplitude der n-ten Oberwelle gleich:

$$U_n = [(16H_{max})/(n.\pi.H_s)]\mu_0 . \mu_r^* . n_2 . f_1 . F . H_s .$$

$$\sin[(n.\pi.H_s)/(2H_{max})] . \sin[(n.\pi/2)(1+H_0/H_{max})] \tag{1}$$

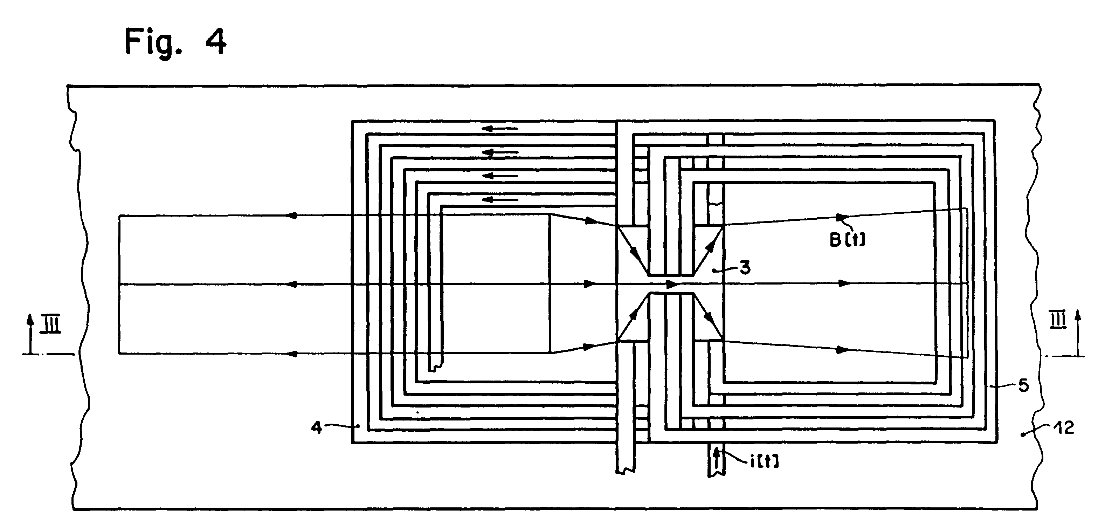

Dabei ist $\mu_o$ die Permeabilität des Vakuums, $\mu_r^*$ die effektive relative Permeabilität ("appearing permeability") des Magnetkreises 2;3 und damit die Neigung tga der Sensorkennlinie B(H) ausserhalb des Sättigungsbereichs (siehe Fig. 2), $n_2$ die Windungszahl der Messspule 5, $f_1$ die Frequenz der Grundwelle des Erregerstromes i[t] und damit der Grundwelle der Ausgangsspannung u[t], F die Fläche des Querschnittes des Kerns 3 und $H_{max}$ die Amplitude des Erregermagnetfeldes H[t]. Bei einem H-förmigen ferromagnetischen Kern 3 (siehe Fig. 4), der aus zwei relativ breiten Hauptstegen und einem schmalen länglichen Quersteg besteht, ist F die Fläche des senkrecht zur Längsachse verlaufenden Querschnittes des Querstegs. Die effektive relative Permeabilität $\mu_r^*$ des Magnetkreises 2;3 ist bekanntlich gleich $1/[N + (1/\mu_r)]$, wobei N der sogenannte Entmagnetisierungsfaktor und $\mu_r$ die relative Permeabilität des ferromagnetischen Materials des Kerns 3 ist.

Mit Hilfe des Verstärkers 9 wird die stärkste geradzahlige Oberwelle, d. h. die zweite Oberwelle aus der Sensorausgangsspannug u[t] herausgefiltert. In diesem Fall ist n=2 und die Gleichung (1) ergibt als Amplitude der herausgefilterten zweiten Oberwelle:

$$U_2 = [(16H_{max})/(2\pi.H_s)].\mu_0.\mu_r^*.n_2.f_1.F.H_s.\sin[\pi.H_s/H_{max}].\ \sin[\pi(1+H_0/H_{max})]$$

$$= [8H_{max}/\pi].\mu_0.\mu_r^*.n_2.f_1.F.\sin[\pi.H_s/H_{max}].\sin[(\pi.H_0)/H_{max}]$$

$$\approx [8H_{max}/\pi].\mu_0.\mu_r^*.n_2.f_1.F.\sin[\pi.H_s/H_{max}].[(\pi.H_0)/H_{max}]$$

$$\approx 8.\mu_0.\mu_r^*.n_2.f_1.F.H_0.\sin[\pi.H_s/H_{max}] \tag{2},$$

da $H_0$ bedeutend kleiner als $H_{max}$ ist.

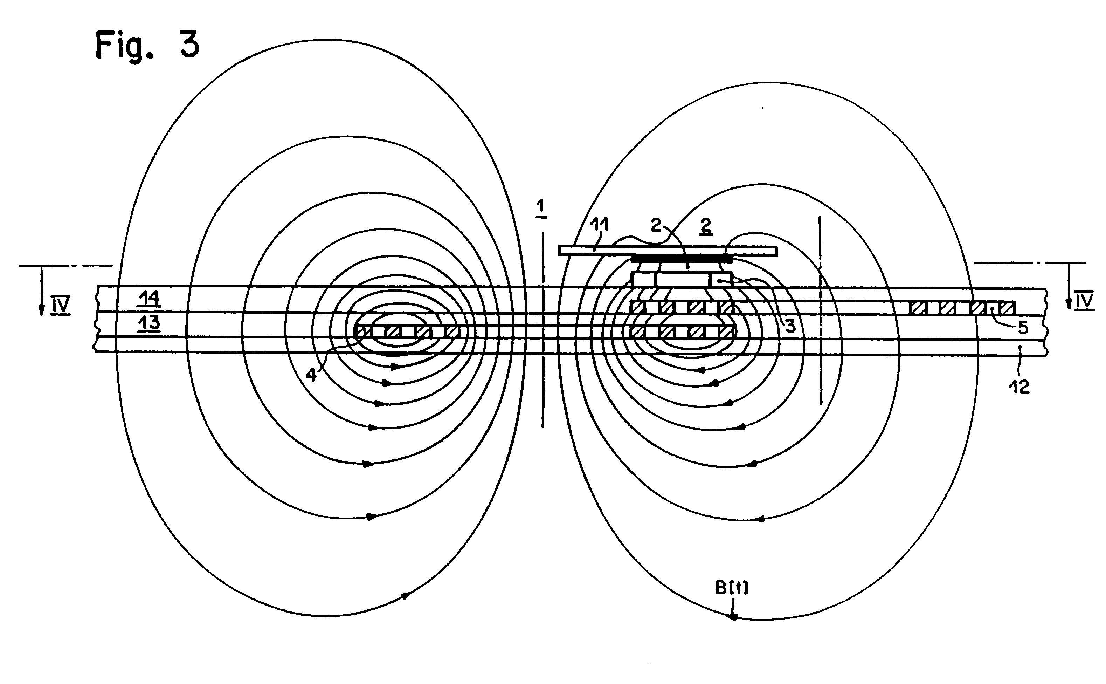

Der ferromagnetische Kern 3 ist als Filmschicht ausgebildet und die Messspule 5 besteht aus einer einzigen Schicht, wobei die Messspule 5 und der ferromagnetische Kern 3 elektrisch isoliert in zwei getrennten und parallelen Schichten auf einer Aussenfläche eines Trägermaterials 12 angeordnet sind. Die Erregerspule 4 ist dann vorzugsweise so ausgebildet, dass der Sensor 1 ein planarer flacher Sensor ist und den in der Fig. 3 und der Fig. 4 dargestellten Aufbau besitzt. Die Erregerspule 4 ist in diesem Fall so ausgebildet, dass sie ebenfalls aus einer einzigen Schicht besteht, wobei sie elektrisch isoliert in einer getrennten und zu den Schichten des ferromagnetischen Kerns 3 und der Messspule 5 parallelen Schicht auf der Aussenfläche des Trägermaterials 12 angeordnet ist.

In der Fig. 3 ist die magnetische Tinte schematisch in Gestalt eines schwarzen Rechteckes an der Unterseite der Banknote 11 dargestellt. Die beiden Spulen 4 und 5 sind jeweils Einschichtspulen, die durch eine erste Isolierschicht 13 elektrisch gegeneinander isoliert in zwei getrennten und parallelen Schichten auf dem Trägermaterial 12, z. B. einem Substrat angeordnet sind. Das Trägermaterial besteht z. B. aus Keramik oder einem anderen billigen und isolierenden Material. Wenn die Messspule 5 rechteckspiralförmig ist, dann ist die Erregerspule 4 ebenfalls bevorzugt rechteckspiralförmig. Die Erregerspule 4 und die Messspule 5 sind dann in ihren jeweiligen Schichten so angeordnet, dass ein aus geraden und parallelen Leitern bestehendes Viertel der Erregerspule 4 und der Messspule 5 sich mindestens teilweise decken.

Der ferromagnetische Kern 3 ist dünn und weist eine annähernd konstante Dicke auf. In der Fig. 3 ist er durch eine zweite Isolierschicht 14 elektrisch isoliert in einer parallelen dritten Schicht auf diejenige der beiden Schichten angeordnet, die die Erregerspule 5 enthält. Der ferromagnetische Kern 3 ist dabei in seiner Schicht so angeordnet, dass er sich mindestens teilweise mit dem sich deckenden Teil der Erregerspule 4 und der Messspule 5 deckt. In der Fig. 3 ist die Erregerspule 4 in einer ersten Schicht auf das Trägermaterial 12 aufgetragen, während die Messspule 5 ihrerseits in einer zweiten Schicht auf die erste Isolierschicht 13 aufgetragen ist. Der Kern 3 ist in einer dritten Schicht auf die zweite Isolierschicht 14 aufgetragen. Der Luftspalt 2 des Magnetkreises 2;3 ist gebildet durch den ausserhalb des ferromagnetischen Kerns 3 zwischen der oberen und der unteren parallelen Fläche desselben gelegenen Raum.

In einer ersten Untervariante, die in der Fig. 4 dargestellt ist, besitzt der ferromagnetische Kern 3 in seiner Schicht, d. h. in der Draufsicht, eine H-förmige Gestalt.

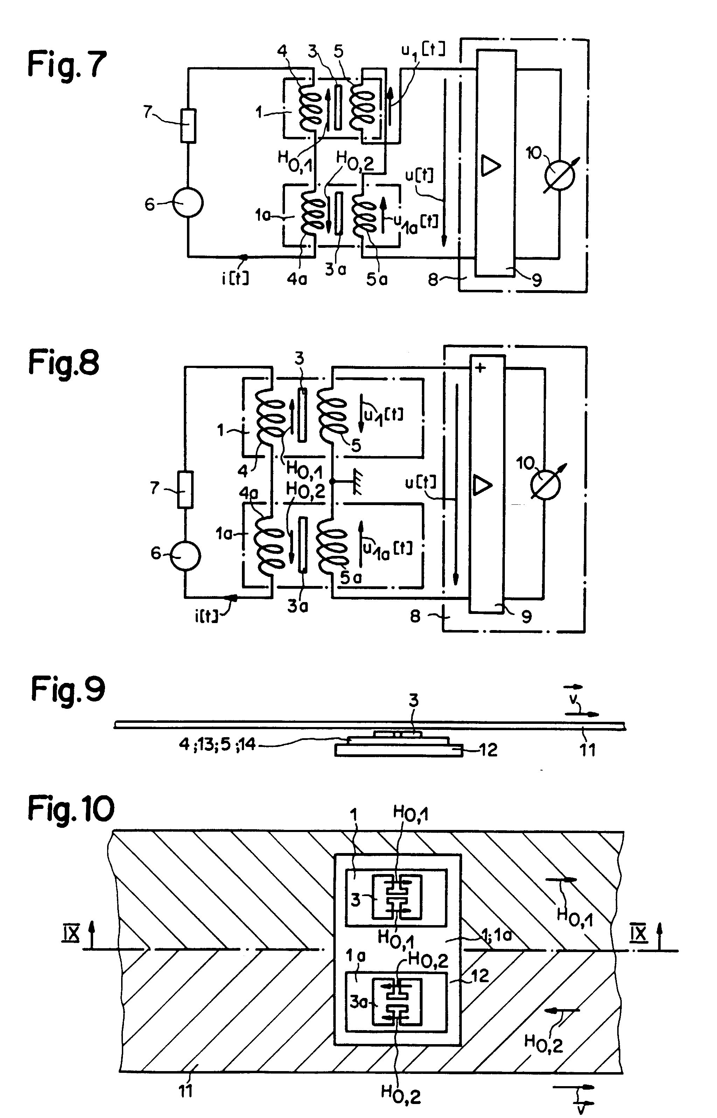

In einer zweiten Untervariante, die in der Fig. 5 dargestellt ist, besitzt der ferromagnetische Kern 3 in seiner Schicht die Gestalt einer rechteckförmigen Acht, deren oberer und unterer Querbalken je einen weiteren Luftspalt 15 bzw. 16 aufweist, die unter sich parallel sind. Wenn eine Banknote an den Luftspalten 15 und 16 vorbeigeführt wird, bilden die beiden letzteren je einen Arbeitsluftspalt, der als Leseluftspalt verwendet werden kann zum Lesen des Informationsinhaltes je einer von zwei Spuren magnetischen Materials, welches auf der Banknote aufgetragen ist.

Die H-förmige oder achtförmige Gestalt des Kerns 3 dient der Flusskonzentration. Eine möglichst starke Einschnürung in der Mitte des Kerns 3, d. h. ein möglichst schmaler mittlerer Quersteg des H-förmigen oder achtförmigen Kerns 3, ist anzustreben, um einen möglichst niedrigen Entmagnetisierungsfaktor N zu erzielen. Die Breite des mittleren Querstegs beträgt z. B. 0,5 mm und seine Länge z. B. 4 mm. Aus demselben Grund ist auch eine möglichst kleine Kerndicke t zu erstreben, was besonders gut erreichbar ist, wenn der Sensor in einer planaren Mikrotechnologie hergestellt wird. Der Kern 3 besitzt vorzugsweise eine minimale Kerndicke t von annähernd 0,025 mm in einer Hybridtechnologie bzw. 0,5 μm in einer planaren Mikrotechnologie. Das Material des ferromagnetischen Kerns 3 besteht vorzugsweise aus magnetisch amorphem Metall, welches im englischen Sprachgebiet als Magnetglas bezeichnet wird. Die Breite der Hauptstege des H-förmigen Kerns 3 ist z. B. jeweils 5 mm, während ihre Länge z. B. jeweils 40 bis 60 mm beträgt.

Bei der Verwendung des achtförmigen Kerns 3 ist nicht nur eine Detektion der Anwesenheit, sondern auch ein Lesen der Gestalt der magnetischen Substanz möglich, da die beiden äusseren Querstege des achtförmigen Kerns 3 zwei Zeilen der Banknote lesen können, so dass der Wert der Banknote mit grosser Sicherheit ermittelt werden kann.

In einer dritten Untervariante, die in der Fig. 6 dargestellt ist, besitzt der ferromagnetische Kern 3 in seiner Schicht die Gestalt der halben, in der Fig. 5 dargestellten rechteckförmigen Acht. Seine Gestalt entspricht dann z. B. der in der Darstellung der Fig. 5 oberen Hälfte der rechteckförmigen Acht. In diesem Fall besitzt der ferromagnetische Kern 3 in seiner Schicht die Gestalt eines rechteckförmigen Ringes, der einen einzigen weiteren Luftspalt 15 aufweist.

In der zweiten und dritten Untervariante ist die Richtung des zu ermittelnden flussarmen Magnetfeldes $H_0$ parallel zu den Längen der weiteren Luftspalte 15 und 16 bzw. des weiteren Luftspaltes 15 (siehe Fig. 5 und Fig. 6).

Wie in der Fig. 7 und der Fig. 8 dargestellt, sind in der erfindungsgemässen Anordnung zwei gleiche Sensoren 1 und 1a vorhanden, die zusammen einen Doppelsensor 1;1a bilden und je einen getrennten ferromagnetischen Kern 3 bzw. 3a besitzen. Der Sensor 1a besitzt eine Erregerspule 4a und eine Messspule 5a. Die Erregerspulen 4 und 4a der beiden Sensoren 1 und 1a sind gleichsinnig in Reihe geschaltet, während dagegen die Messspulen 5 und 5a der beiden Sensoren 1 und 1a so miteinander verbunden sind, dass im Betrieb eine Differenz ihrer Ausgangsspannungen $u_1[t]$ und $u_{1a}[t]$ als Spannung $u[t]$ am Ausgang des Doppelsensors 1;1a vorhanden ist. In einer Variante (siehe Fig. 7) sind dazu die Messspulen 5 und 5a der beiden Sensoren 1 und 1a gegensinnig in Reihe geschaltet. In einer weiteren Variante (siehe Fig. 8) sind dagegen dazu die Messspulen 5 und 5a der beiden Sensoren 1 und 1a gleichsinnig in Reihe geschaltet, wobei ihr gemeinsamer Pol an einem Bezugspotential, z. B. Masse oder Erde, liegt. Ausserdem sind die beiden Pole der Reihenschaltung 5;5a der beiden Messspulen 5 und 5a der beiden Sensoren 1 und 1a jeweils mit einem invertierenden und einem nichtinvertierenden Eingang des Verstärkers 9 verbunden.

Der Generator 6 speist über den Vorwiderstand 7 die Reihenschaltung 4;4a der Erregerspulen 4 und 4a mit dem zeitlich periodisch variablen Strom i[t], der beide Kerne 3 und 3a gleichzeitig zeitweise in die Sättigung treibt. Die an der Reihenschaltung 5;5a der Messspulen 5 und 5a anstehende Spannung ist die Ausgangsspannung u[t] des Doppelsensors 1;1a. Die Ausgangsspannung $u[t] = u_1[t] - u_{1a}[t]$ ist auf den Eingang der Anordnung 8 geführt, die ähnlich aufgebaut ist wie diejenige der Fig. 1, mit dem Unterschied, dass der Verstärker 9 kein Bandpassverstärker mehr ist, sondern ein Breitbandverstärker.

Die vorliegenden Ausführungsbeispiele haben als einen ersten Vorteil, dass das Erdmagnetfeld $H_{Erde}$ automatisch eliminiert wird, da für jede Harmonische die Gleichung

$$U_n = [(16H_{max})/(n.\pi)].\mu_0.\mu_r^*.n_2.f_1.F.\sin[(n.\pi.H_s)/(2H_{max})].$$

$$\{\sin[(n.\pi/2)(1+H_{Erde}/H_{max})] - \sin[(n.\pi/2)(1+H_{Erde}/H_{max})]\} = 0$$

gilt.

In der Fig. 9 und der Fig. 10 ist der räumliche Aufbau des Doppelsensors 1;1a dargestellt, wobei für den Kern 3 die Gestalt desjenigen der zweiten Untervariante angenommen wurde. Die beiden Sensoren 1 und 1a sind auf einem gleichen Trägermaterial 12 aufgetragen und annähernd parallel auf demselben angeordnet. Eine Banknote 11 wird oberhalb des Doppelsensors 1;1a parallel zur Länge der Luftspalte 15 und 16 mit einer konstanten Geschwindigkeit v vorbei bewegt.

Die magnetische Tinte einer ersten Hälfte der Banknote 11 wird oberhalb des Sensors 1 fortbewegt, während die magnetische Tinte einer zweiten Hälfte der Banknote 11 oberhalb des Sensors 1a fortbewegt wird, wobei die beiden Hälften der Banknote 11 zwei parallel zur Fortbewegungsrichtung der Banknote 11 verlaufende Streifen bilden. Die magnetische Tinte ist dabei parallel zur Bewegungsrichtung magnetisiert. Wenn die beiden Hälften der Banknote 11 in einem gleichen Richtungssinn magnetisiert sind, dann misst der Doppelsensor 1;1a eine Magnetfelddifferenz, die ähnlich wie bei der Messung des Erdmagetfeldes $H_{Erde}$ gleich Null ist, wenn die Magnetfelder beider Banknotenhälften gleich gross sind, was ausnahmsweise in einigen Messstellen der Banknote 11 der Fall ist. In der Regel sind jedoch zwei gerade durch die Sensoren 1 und 1a gemessene Stellen der Banknote 11 unterschiedlich stark magnetisiert, da dort unterschiedliche Quantitäten magnetischer Tinte vorhanden sind, so dass die gemessene Magnetfelddifferenz in der Regel ebenfalls unterschiedlich von Null ist.

In einer bevorzugt verwendeten Ausführung wird jedoch die magnetische Tinte der ersten Hälfte der Banknote 11 in positiver Bewegungsrichtung magnetisiert, während die magnetische Tinte der zweiten Hälfte der Banknote 11 in negativer Bewegungsrichtung magnetisiert wird. Mit anderen Worten: Der Sensor 1 misst ein Magnetfeld $H_{0,1}$ und der Sensor 1a ein Magnetfeld $H_{0,2}$, die beide einen umgekehrten Richtungssinn besitzen.

Der letzte Sinusfaktor in der Gleichung (1) kann folgendermassen umformuliert werden:

$$\sin[(n.\pi/2)(1+H_0/H_{max})] = \sin(n.\pi/2).\cos[(n.\pi/2)(H_0/H_{max})] +$$

$$\cos(n.\pi/2).\sin[(n.\pi/2)(H_0/H_{max})]$$

Für geradzahlige Harmonische ist der letzte Sinusfaktor der Gleichung (1) dann:

$$(+/-)\sin[(n.\pi/2)(H_0/H_{max})] \qquad (3).$$

Da $u[t] = u_1[t] - u_{1a}[t]$, sind die Amplituden der geradzahligen Harmonischen der Ausgangsspannung $u[t]$ des Doppelsensors 1;1a proportional

$$U_n =$$

$$\{(+/-)\sin[(n.\pi/2)(H_{0,1}/H_{max})]\} - \{(+/-)\sin[(n.\pi/2)(-H_{0,2}/H_{max})]\}$$

$$= \{(+/-)\sin[(n.\pi/2)(H_{0,1}/H_{max})]\} + \{(+/-)\sin[(n.\pi/2)(H_{0,2}/H_{max})]\}$$

$$\approx (+/-)[(n.\pi/2H_{max})H_{0,1} + H_{0,2})]$$

da $\sin(-\alpha) = -\sin\alpha$ und $H_{0,1}$ sowie $H_{0,2}$ bedeutend kleiner als $H_{max}$ sind. D. h. die Messbeiträge der geradzahligen Harmonischen der beiden Sensoren 1 und 1a addieren sich, unter der Voraussetzung, dass beide Sensoren 1 und 1a genau identisch sind.

Für ungeradzahlige Harmonische ist der letzte Sinusfaktor der Gleichung (1) dagegen:

$$(+/-)\cos[(n.\pi/2)(H_0/H_{max})] \qquad (4).$$

Die Amplituden der ungeradzahligen Harmonischen der Ausgangsspannung $u[t]$ des Doppelsensors 1;1a sind somit proportional

$$U_n =$$

$$\{(+/-)\cos[(n.\pi/2)(H_{0,1}/H_{max})]\} - \{(+/-)\cos[(n.\pi/2)(-H_{0,2}/H_{max})]\}$$

$$= \{(+/-)\cos[(n.\pi/2)(H_{0,1}/H_{max})]\} - \{(+/-)\cos[(n.\pi/2)(H_{0,2}/H_{max})]\}$$

$$\approx 0$$

da $\cos(-\alpha) = \cos\alpha$ und $H_{0,1}$ sowie $H_{0,2}$ bedeutend kleiner als $H_{max}$ sind. D. h. die Messbeiträge der ungeradzahligen Harmonischen der beiden Sensoren 1 und 1a subtrahieren sich unter der Voraussetzung, dass beide Sensoren 1 und 1a genau identisch sind.

Anders ausgedrückt, die Amplituden aller ungeradzahligen Harmonischen der Ausgangsspannung $u[t]$ des Doppelsensors 1;1a sind gleich Null und eliminieren sich auch ohne nachgeschaltetes Filter automatisch. Der Verstärker 9 benötigt somit keine Filterwirkung mehr und muss ein Breitbandverstärker sein.

Da in der Dickfilmtechnik, ähnlich wie in der Integrierten Schaltungs-Technik, eine Vielzahl von Kernen und Spulen ausschliesslich mittels eines "batch processing" und mit Hilfe von auf photolitographischer Weise hergestellten Masken auf einem einzigen Substrat hergestellt werden können, ist die Herstellung der Sensoren 1, 1a und 1;1a sehr preisgünstig und hochpräzis, so dass die Sensoren 1 und 1a praktisch identisch hergestellt werden können, da einerseits die geometrische Abmessungen der Spulen und der Kerne sehr genau eingehalten werden können und anderseits keine dreidimensionale Montage derselben mehr erforderlich ist. Für eine Kompensation der störenden Oberwellen ist ausserdem ausschlaggebend, dass die ferromagnetischen Kerne 3 und 3a der beiden Sensoren 1 und 1a gleiche koerzitive Magnetfeldstärken aufweisen, was durch Verwendung von Magnetglas für die ferromagnetischen Kerne 3 und 3a erreicht wird, da Magnetglas eine praktisch vernachlässigbare koerzitive Magnetfeldstärke von 0,4 A/m (4 mA/cm) besitzt.

## Patentansprüche

1. Vorrichtung zum Messen magnetischer Felder geringer Flußdichte nach dem Kernsättigungsprinzip mit zwei praktisch identischen Sensoren (1, 1a), deren jeder eine Erregerspule (4; 4a) und eine Meßspule (5, 5a), die jeweils in einer einzigen Schicht ausgebildet sind, sowie einen als Filmschicht ausgebildeten ferromagnetischen Kern (3; 3a) aufweist, wobei die Erregerspule (4; 4a), die Meßspule (5; 5a) und der ferromagnetische Kern (3; 3a) jeweils in einer getrennten, elektrisch isolierten und zu den anderen Schichten parallelen Schicht auf der Oberfläche eines Trägermaterials (12) so ausgebildet sind, daß der Sensor (1; 1a) planar und flach ist, und wobei die Erregerspulen (4; 4a) der beiden Sensoren (1, 1a) gleichsinnig in Serie liegen und die Meßspulen (5; 5a) der beiden Sensoren (1, 1a) so geschaltet sind, daß sie als Ausgang eine Differenz zwischen ihren beiden Spannungen (u1[t], u1a[t]) ergeben.

2. Vorrichtung nach Anspruch 1, wobei die Meßspulen (5; 5a) der beiden Sensoren (1, 1a) in Serie liegen.

3. Vorrichtung nach Anspruch 2, wobei die Meßspulen (5; 5a) der beiden Sensoren (1, 1a) gegensinnig in Serie liegen.

4. Vorrichtung nach Anspruch 2, wobei die Meßspulen (5; 5a) der beiden Sensoren (1, 1a) unter Verbindung ihres gemeinsamen Anschlusses mit einer Bezugsspannung gleichsinnig in Serie liegen und die anderen Pole der Serienschaltung aus den beiden Meßspulen (5; 5a) mit einem invertierenden bzw. einem nicht-invertierenden Eingang eines Verstärkers (9) verbunden sind.

5. Vorrichtung nach einem der vorhergehenden Ansprüche, wobei in jedem der Sensoren (1, 1a) sowohl die Meßspule (5, 5a) als auch die Erregerspule (4, 4a) rechteck-spiralförmig und so angeordnet sind, daß parallele Leiter einer Seite der Erregerspule (4, 4a) und parallele Leiter einer Seite des Meßspule (5, 5a) einander überlappen.

6. Vorrichtung nach Anspruch 5, wobei der ferromagnetische Kern (3, 3a) den Überlappungsbereich von Erreger- und Meßspule (4, 4a, 5, 5a) mindestens teilweise überlappt.

7. Vorrichtung nach einem der vorhergehenden Ansprüche, wobei der ferromagnetische Kern (3, 3a) jedes der Sensoren (1, 1a) in Aufsicht H-förmig ist.

8. Vorrichtung nach einem der Ansprüche 1 bis 6, wobei der ferromagnetische Kern (3, 3a) jedes der Sensoren (1, 1a) in Aufsicht die Gestalt einer rechteckförmigen Acht mit einem Luftspalt (15, 16) sowohl in seinem oberen als auch in seinem unteren Querbalken aufweist.

9. Vorrichtung nach einem der Ansprüche 1 bis 6, wobei der ferromagnetische Kern (3, 3a) jedes der Sensoren (1, 1a) in Aufsicht eine rechteckige Ringform mit einem Luftspalt (15) aufweist.

10. Vorrichtung nach einem der vorhergehenden Ansprüche, wobei der ferromagnetische Kern (3, 3a) jedes der Sensoren (1, 1a) aus Magnetglas gebildet ist.

## Claims

1. A device for measuring low-flux magnetic fields by the core saturation principle, comprising two practically identical sensors (1, 1a) each of which comprises an excitation coil (4; 4a) and a measuring coil (5, 5a) each formed in a single layer, and a ferromagnetic core (3; 3a) formed as a film layer, wherein each of the excitation coil (4; 4a), the measuring coil (5; 5a) and the ferromagnetic core (3; 3a) is formed in a separate, electrically insulated, layer parallel to the other layers on the surface of a support material (12) so that the sensor (1; 1a) is flat and planar, and wherein the excitation coils (4; 4a) of the two sensors (1, 1a) are connected in series in the same sense and the measuring coils (5; 5a) of the two sensors (1, 1a) are connected so as to provide a difference between their two voltages (u1[t], u1a[t]) as an output.

2. A device as claimed in claim 1, wherein the measuring coils (5; 5a) of the two sensors (1, 1a) are connected in series.

3. A device as claimed in claim 2, wherein the measuring coils (5; 5a) of the two sensors (1, 1a) are connected in series in opposite senses.

4. A device as claimed in claim 2, wherein the measuring coils (5; 5a) of the two sensors (1, 1a) are connected in series in the same sense, with their common terminal connected to a reference voltage, and the other poles of the series circuit of the two measuring coils (5; 5a) are connected respectively to an inverting and a non-inverting input of an amplifier (9).

5. A device as claimed in any preceding claim, wherein in each of the sensors (1, 1a) both the measuring coil (5, 5a) and the excitation coil (4, 4a) are rectangular-spiral-shaped and are arranged so that parallel conductors of one side of the excitation coil (4, 4a) and parallel conductors of one side of the measuring coil (5, 5a) overlap.

6. A device as claimed in claim 5, wherein the ferromagnetic core (3, 3a) at least partially overlaps the overlapping region of the excitation coil (4, 4a) and the measuring coil (5, 5a).

7. A device as claimed in any preceding claim, wherein the ferromagnetic core (3, 3a) of each of the sensors (1, 1a) is H-shaped in plan view.

8. A device as claimed in any one of claims 1 to 6, wherein the ferromagnetic core (3, 3a) of each of the sensors (1, 1a) has in plan view the shape of a rectangular figure-of-eight with an air gap (15, 16) both in its upper and in its lower cross strip.

9. A device as claimed in any one of claims 1 to 6, wherein the ferromagnetic core (3, 3a) of each of the sensors (1, 1a) has in plan view a rectangular ring shape with an air gap (15).

10. A device as claimed in any preceding claim, wherein the ferromagnetic core (3, 3a) of each of the sensors (1, 1a) is made of magnetic glass.


**Revendications**

1. Dispositif de mesure de champs magnétiques de faible densité de flux selon le principe de la saturation de noyau au moyen de deux capteurs pratiquement identiques (1, 1a), qui comprennent chacun une bobine excitatrice (4, 4a) et une bobine de mesure (5, 5a) qui sont respectivement formées dans une couche unique, ainsi qu'un noyau ferromagnétique (3; 3a) réalisé sous forme de couche de film, la bobine excitatrice (4; 4a), la bobine de mesure (5; 5a) et le noyau ferromagnétique (3; 3a) étant réalisés chacun- dans une couche séparée, électriquement isolée et parallèle aux autres couches sur la surface d'une matière de support (12) d'une manière telle que le capteur (1; 1a) est plan et plat, les bobines excitatrices (4; 4a) des deux capteurs (1; 1a) étant situées en série dans le même sens et les bobines de mesure (5; 5a) des deux capteurs (1; 1a) étant montées d'une manière telle que la sortie qui en résulte est la différence entre leurs deux tensions ($u_1[t]$, $u_{1a}[t]$).

2. Dispositif selon la revendication 1, dans lequel les bobines de mesure (5; 5a) des deux capteurs (1, 1a) sont disposées en série.

3. Dispositif selon la revendication 2, dans lequel les bobines de mesure (5; 5a) des deux capteurs (1, 1a) sont disposées en série en sens contraires.

4. Dispositif selon la revendication 2, dans lequel les bobines de mesure (5; 5a) des deux capteurs (1, 1a) sont montées en série dans le même sens, leur connexion commune étant reliée à la tension de référence et les autres pôles du circuit en série formé des deux bobines de mesure (5; 5a) étant reliés à une entrée à inversion et à une entrée sans inversion d'un amplificateur (9).

5. Dispositif selon l'une quelconque des revendications précédentes, dans lequel tant la bobine de mesure (5, 5a) que la bobine excitatrice (4; 4a) sont en forme de spirales rectangulaires dans chacun des capteurs (1, 1a) et sont agencées d'une manière telle que des conducteurs parallèles d'un côté de la bobine excitatrice (4, 4a) et des conducteurs parallèles d'un côté d'une bobine de mesure (5, 5a) se recouvrent les uns les autres.

6. Dispositif selon la revendication 5, dans lequel le noyau ferromagnétique (3; 3a) recouvre au moins en partie la zone de recouvrement de la bobine excitatrice et de la bobine de mesure (4, 4a, 5, 5a).

7. Dispositif selon l'une quelconque des revendications précédentes, dans lequel le noyau ferromagnétique (3, 3a) de chacun des capteurs (1, 1a) est en forme de H en vue en plan.

8. Dispositif selon l'une quelconque des revendications 1 à 6, dans lequel la configuration due noyau ferromagnétique (3, 3a) de chacun des capteurs (1, 1a) est en vue en plan un huit comportant des entrefers (15, 16) tant dans sa barre supérieure que dans sa barre inférieure.

9. Dispositif selon l'une quelconque des revendications 1 à 6, dans lequel le noyau ferromagnétique (3, 3a) de chacun des capteurs (1, 1a) est d'une forme annulaire rectangulaire comportant-en vue en plan un entrefer (15).

10. Dispositif selon l'une quelconque des revendications précédentes, dans lequel le noyau ferromagnétique (3, 3a) de chacun des capteurs (1, 1a) est en verre magnétique.

Fig. 1

Fig. 2

Fig. 5

Fig. 6

Fig. 3

EP 0 511 434 B1

Fig. 4

B(t)

3

4

5

12

i(t)

III

III

Fig. 7

Fig. 8

Fig. 9

Fig. 10